Europäisches Patentamt

European Patent Office

Office européen des brevets

(19)

(11) Numéro de publication: **0 229 555
B1**

(12) **FASCICULE DE BREVET EUROPEEN**

(45) Date de publication du fascicule du brevet:
13.09.89

(51) Int. Cl.⁴: **C04B 35/46, H01L 41/18**

(21) Numéro de dépôt: 86402692.7

(22) Date de dépôt: 04.12.86

(54) Composition de matériaux ferroélectriques.

(30) Priorité: 06.12.85 FR 8518079

(43) Date de publication de la demande:
22.07.87 Bulletin 87/30

(45) Mention de la délivrance du brevet:
13.09.89 Bulletin 89/37

(84) Etats contractants désignés:
DE FR GB IT NL

(56) Documents cités:
DE-A- 3 508 797

PATENTS ABSTRACTS OF JAPAN,
vol. 5, no. 192 (E-85)[864], 8 décembre 1981; &
JP-A-56 115 585 (TOKYO SHIBAURA DENKI
K.K.) 10-09-1981
PATENTS ABSTRACTS OF JAPAN,
vol. 6, no. 189 (E-133)[1067], 28 septembre 1982; &
JP-A-57 101 498 (NIPPON DENKI K.K.) 24-06-1982
CHEMICAL ABSTRACTS,
vol. 87, no. 24, décembre 1977, page 563, résumé
no. 192712z, Columbus, Ohio, US; &
JP-A-77 71 698 (NIPPON ELECTRIC CO.,
LTD) 15-06-1977

(73) Titulaire: QUARTZ ET SILICE, "Les Miroirs" 18 avenue
d'Alsace, F-92400 Courbevoie(FR)

(72) Inventeur: Eyraud, Lucien, 7, rue des Noyers,
F-69005 Lyon(FR)
Inventeur: Eyraud, Paul, Les Jardins d'Arcadie,
F-69130 Ecully(FR)
Inventeur: Fillot, Jean-Jacques, 36, rue de Cherelles,
F-77140 Nemours(FR)

(74) Mandataire: Breton, Jean-Claude, SAINT-GOBAIN
RECHERCHE 39, quai Lucien Lefranc,
F-93300 Aubervilliers Cedex(FR)

## Description

La présente invention concerne des matériaux qui possèdent une structure perovskite du type $ABO_3$.

Elle se rapporte plus précisément à des céramiques à base de titanate de plomb dans lesquelles on substitue divers éléments à une partie du titane et du plomb.

Le titanate de plomb simple, à l'état de céramique frittée, n'offre pas d'intérêt car le matériau obtenu est poreux et cassant et qu'il est difficile de le polariser. En substituant divers ions métalliques à une partie des ions $Pb^{2+}$ et $Ti^{4+}$ il a déjà été démontré que les propriétés mécaniques, électriques et piézoélectriques pouvaient être considérablement améliorées.

Ces propriétés varient sensiblement selon la nature des ions remplaçant le plomb et le titane, selon leur teneur dans le matériau, mais également selon le mode d'obtention dudit matériau.

L'amélioration des propriétés des matériaux à base de $PbTiO_3$ par voie de substitution et, pour un type de substitution donné, leur variation en fonction de la formulation desdits matériaux peuvent être illustrées par le brevet US 4 321 155.

Ce brevet décrit des céramiques dont la composition résulte de substitutions sur le site A et le site B : le calcium en remplacement partiel du plomb sur le site A, le cobalt et le tungstène en remplacement partiel du titane sur le site B. La modification du site A confère à la céramique un coefficient de couplage électromécanique transversal $k_p$, relativement faible et un coefficient de couplage électromécanique longitudinal $k_t$, relativement élevé, d'où un rapport $k_t/k_p$ particulièrement élevé.

Autrement dit, ce type de céramique se caractérise par une grande anisotropie électromécanique intrinsèque, ce qui en fait un matériau de choix pour toutes les applications en haute fréquence, par exemple. Cette caractéristique n'est obtenue que si 20 à 35 % en poids atomique de plomb est remplacé par du calcium.

D'autre part les propriétés mécaniques, électriques et piézoélectriques dépendent énormément du procédé de fabrication choisi pour l'obtention du matériau.

Il existe actuellement de nombreux composés ferroélectriques dont les propriétés sont intrinsèquement intéressantes, mais qui ne peuvent être obtenus que par réaction d'oxydes en phase solide. Cette méthode de fabrication est longue, pénible et coûteuse du fait des risques de pollution au moment des broyages, de la difficulté d'accomplir des réactions en phase solide et de la volatilisation de certains constituants pendant l'opération de frittage.

Les céramiques ainsi obtenues ne présentent ni l'homogénéité, ni la composition exacte, ni la rigidité exigées dans bon nombre d'applications.

Il existe des méthodes de fabrication par voie liquide, dont certaines comme celle proposée par Lucien et Paul EYRAUD dans les articles suivants : L'INDUSTRIE CERAMIQUE, n° 761, 5/82, 343-351 ; FERROELECTRICS vol. 34, 1981, 133-138 ; C.R. ACAD. SC. PARIS, 288, 2/79, 115-118, peuvent atteindre un rendement de 100 %. Cette méthode fondée sur la coprécipitation en voie aqueuse d'oxalates multiples donne toute satisfaction, mais elle présente une sérieuse limite : tous les ions ne sont pas coprécipitables, en particulier certains d'entre eux comme le cobalt ou le tungstène.

La présente invention a pour but de trouver une solution à ce double problème de l'amélioration des propriétés intrinsèques des composés ferroélectriques et leur aptitude à être élaborés par un procédé performant.

L'invention a donc pour objet la mise au point d'un composé ferroélectrique susceptible d'être élaboré par un procédé de fabrication par voie liquide.

L'invention a également pour objet une céramique ferroélectrique présentant un ensemble de propriétés optimalisées, en particulier un rapport des facteurs de couplage $k_t/k_p$ le plus élevé possible.

D'une manière plus précise l'invention a pour objet des céramiques ferroélectriques dont le facteur électromécanique longitudinal $k_t$ est supérieur à 50 % et le coefficient de couplage électromécanique transversal $k_p$ est le plus faible possible, de manière que le rapport des deux soit supérieur à 10.

Par ailleurs, les céramiques selon l'invention sont suscepti bles de présenter d'autres caractéristiques intéressantes : des pertes diélectriques tg $\delta$, inférieures ou égales à 1 % ; une constante de charge $d_{33}$, égale ou supérieure à $70.10^{-12}$ C/N ; une constante diélectrique $\varepsilon_r$ au moins égale à 200 et enfin un facteur de surtension pour le mode longitudinal Q, de préférence inférieur à 100.

Ces buts sont atteints par un composé ferroélectrique de structure perovskite du type $A^{2+} B^{4+} O_3$, formé par un titanate de plomb modifié par une substitution isovalente sur le site A comprenant les ions $Pb^{2+}$ et $Ca^{2+}$ et des substitutions hétérovalentes sur le site B, qui répond à la formule générale:

$(Pb_{1-(x+y)} Ca_x Cd_y) (Ti_{1-(v+w+z)} Mn_v Fe_w X_z) O_3$

X représentant l'ion niobium ou l'ion antimoine, et selon laquelle:

$0,22 \leq x \leq 0,30$ ; $0 \leq y \leq 0,18$ ; $0,005 \leq v \leq 0,025$ ;

$0,005 \leq w \leq 0,02$ et $0,01 \leq z \leq 0,035$.

Les avantages de l'invention seront mieux compris grâce à la description détaillée ci-après, illustrée par des figures selon lesquelles :

- la figure 1 est un graphique montrant l'influence de la concentration en $Ca^{2+}$ sur la valeur des coefficients de couplage $k_t$ (%) et $k_p$ (%) et la variation de leur rapport,

- la figure 2 est un graphique montrant l'influence de la concentration en $Cd^{2+}$ sur la valeur des coefficients de couplage $k_t$ (%) et $k_p$ (%) et la variation de leur rapport,

- la figure 3 est un graphique montrant également l'influence de la concentration en $Cd^{2+}$ sur les mêmes caractéristiques que précédemment mais dans une formulation différente.

Les composés répondant à la formule générale précédente sont tous susceptibles d'êtres élaborés par une technique de réaction en phase liquide et par décomposition des oxalates multiples, tels que décrits dans les articles de Lucien et Paul EYRAUD précités.

Dans une solution d'acide oxalique on ajoute du tertiobutylate de titane, du chlorure de niobium ou d'antimoine, du chlorure de fer, de l'acétate de manganèse et du chlorure de cadmium. A dissolution complète an ajoute les sels de plomb et de calcium (acétate et chlorure) en solution dans l'eau. La réaction est complète et le coprécipité mixte, qui contient les différents éléments nommés précédemment, constitue une phase solide parfaitement homogène. Il en est de même du composé résultant de sa décomposition thermique et de la céramique finale frittée.

Après les opérations de lavage et de filtration, le précipité est séché en étuve puis décomposé entre 500 et 800°C. La poudre ainsi obtenue est alors comprimée et frittée sous forme de disques céramiques à une température voisine de 1100°C.

Les principales mesures ont été effectuées sur des disques de 12 mm de diamètre et de 1,5 mm d'épaisseur, polarisés sous un champ de 5 kV/mm à 170°C.

L'introduction du manganèse en site B limite le grossissement des grains dans la solution solide et permet ainsi d'améliorer le frittage.

La quantité de manganèse introduite ne doit pas être trop faible sous peine de provoquer une diminution sensible du rapport des facteurs de couplage. Pour ces raisons, il est préférable de maintenir la quantité de manganèse entre 1 et 2 %.

L'introduction du fer en site B a des effets similaires à ceux du manganèse ; comme lui, il contribue à l'obtention de valeurs intéressantes pour des propriétés telles que la constante diélectrique $\varepsilon_r$, la constante de charge $d_{33}$ et les pertes diélectriques tg $\delta$. Les meilleurs résultats sont obtenus lorsque la concentration en fer est de préférence comprise entre 1 et 2 %.

Le niobium ou l'antimoine permettent notamment d'abaisser la valeur du facteur de couplage électromécanique transversal $k_p$ jusqu'à des niveaux exceptionnellement bas. Ces éléments permettent également d'augmenter la température de Curie du composé obtenu. Les meilleurs résultats sont obtenus lorsque la concentration en niobium ou en antimoine est comprise entre 1,5 et 2,5 %.

Une première série d'exemples de céramiques illustrant l'invention sont rassemblés dans le tableau n° 1 disposé en annexe.

Les valeurs des caractéristriques mesurées, en particulier $k_t$ et $k_p$ reflètent l'effet de synergie obtenu dans une céramique formée d'un composé dont le site A contient du calcium et le site B les trois éléments précités, introduits selon des quantités déterminées.

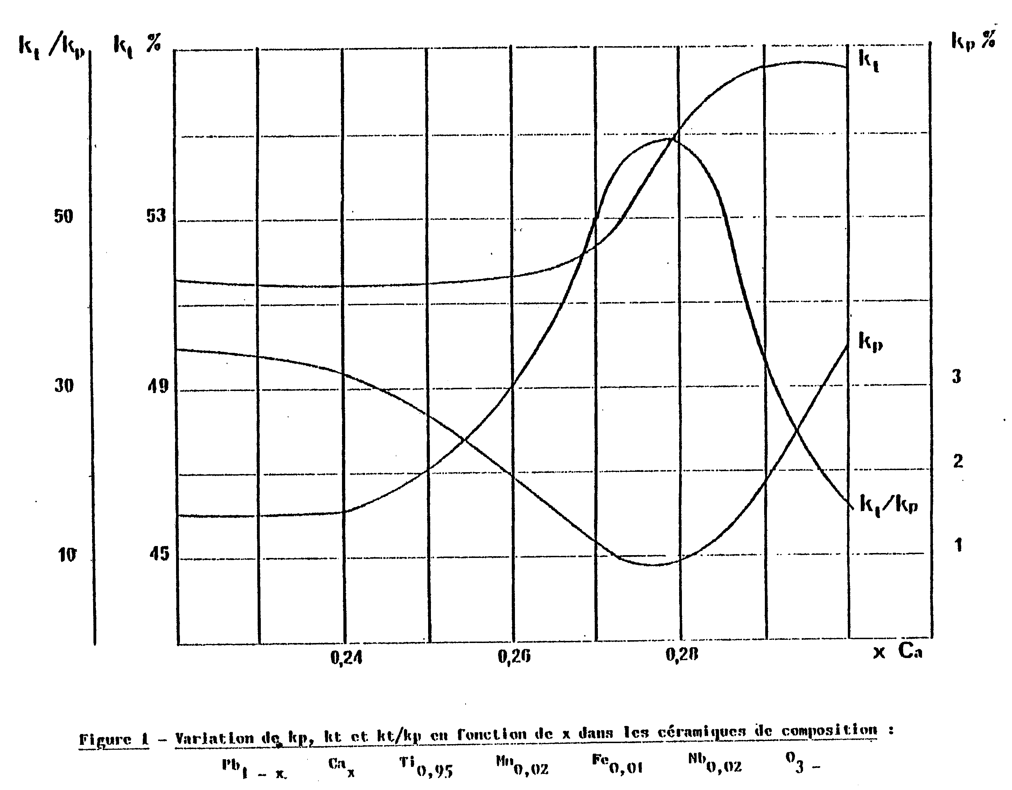

La courbe de la figure 1, qui représente graphiquement la variation des coefficients $k_t$ et $k_p$ desdites céramiques ainsi que celle de leur rapport en fonction du pourcentage de calcium, montre que ledit rapport atteint des valeurs exceptionnellement élevées lorsque le calcium est compris entre 0,24 et 0,30.

Le remplacement du plomb par du cadmium et du calcium permet, en conservant le site B tel que décrit précédemment, non seulement de maintenir un rapport $k_t/k_p$ à un niveau très élevé et de conserver des pertes diélectriques très faibles ainsi qu'une constante de charge égale ou supérieure à $70.10^{-12}$ C/N, mais de dimiuer considérablement la valeur du facteur de surtension pour le mode longitudinal Q.

Des caractéristiques satisfaisantes sont obtenues lorsque la concentration en calcium est comprise entre 22 et 30 % et lorsque la concentration en cadmium demeure inférieure ou égale à 18 %. En effet, au-dessous de 22 % de calcium et/ou au-dessus de 18 % de cadmium, les céramiques obtenues sont plus difficilement polarisables et présentent, de ce fait, des caractéristiques moyennes, voire même médiocres.

La concentration en calcium est, de préférence, supérieure ou égale à 24 % ; celle du cadmium est de préférence comprise entre 0 et 14 %.

Les céramiques présentant l'ensemble de caractéristiques les plus intéressantes contiennent des quantités de calcium et de cadmium telles qu'elles satisfont à la condition suivante :

$$0,28 \leq x + y \leq 0,34.$$

Deux autres séries d'exemples de céramiques illustrant ce type de formulation sont rassemblées dans les tableaux n° et n° 3 en annexe.

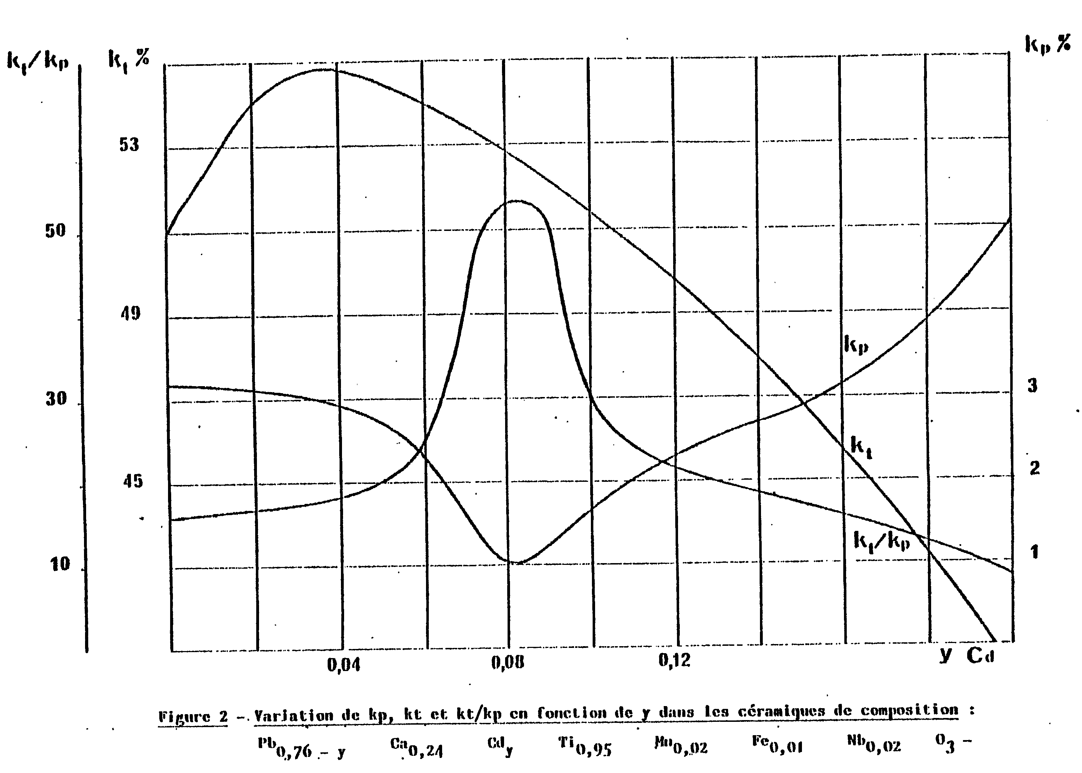

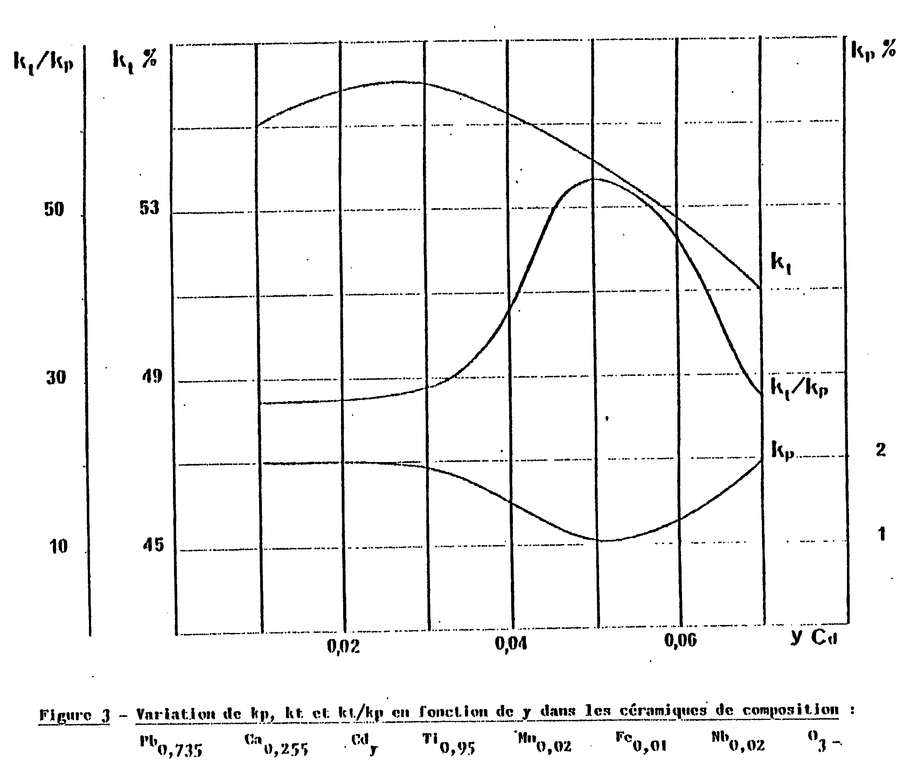

Les courbes des figures 2 et 3 représentent graphiquement la variation des coefficients $k_t$ et $k_p$ desdites céramiques ainsi que celle de leur rapport.

Là encore, on peut noter que le rapport des coefficients de couplage peut parfois dépasser 50 ce qui est considérable.

Pour souligner les avantages des céramiques selon l'invention, le tableau n° 4, en annexe, permet de comparer les caractéristiques de quatre d'entre elles à celles d'une céramique de l'art antérieur le plus proche dont la composition est rappelée à la première ligne.

Les céramiques selon l'invention sont susceptibles d'être utilisées dans de nombreux domaines comme l'imagerie ultrasonore (application au diagnostic médical par exemple), les dispositifs de contrôle non destructif et de détection sous-marine.

Tableau No 1

Formule de base: $(Pb_{1-x} Ca_x)(Ti_{0,95} Mn_{0,02} Fe_{0,01} Nb_{0,02})O_3$

| x | $\varepsilon_r$ | tg δ (%) | $d_{33} \times 10^{-12}$ C/N | $k_t$ (%) | $k_p$ (%) | $k_t/k_p$ (%) |
|---|---|---|---|---|---|---|
| 0,22 | 190 | 0,35 | 61 | 51,5 | 3,5 | 14,7 |
| 0,24 | 195 | 0,60 | 65 | 51,5 | 3,0 | 17 |
| 0,27 | 200 | 0,20 | 71 | 52,0 | 1,0 | 50 |
| 0,28 | 217 | 0,10 | 75 | 55,0 | 1,0 | 55 |
| 0,30 | 250 | 0,20 | 83 | 55,0 | 3,5 | 15,7 |

Tableau No 2

Formule de base: $(Pb_{0,76-y} Ca_{0,24} Cd_y)(Ti_{0,95} Mn_{0,02} Fe_{0,01} Nb_{0,02})O_3$

| y | $\varepsilon_r$ | tg δ (%) | $d_{33} \times 10^{-12}$ C/N | $k_t$ (%) | $k_p$ (%) | $k_t/k_p$ |
|---|---|---|---|---|---|---|
| 0 | 195 | 0,7 | 65 | 51 | 3,2 | 16,0 |
| 0,02 | 195 | 0,3 | 71 | 54 | 3,0 | 18,7 |
| 0,04 | 223 | 0,3 | 72 | 55 | 3,0 | 18,4 |
| 0,06 | 257 | 0,6 | 74 | 54 | 2,3 | 23,5 |
| 0,08 | 260 | 0,8 | 72 | 53 | 1,0 | 53 |
| 0,12 | 270 | 0,8 | 68 | 50 | 2,3 | 21,7 |
| 0,16 | 270 | 0,8 | 60 | 46 | 3,0 | 15,7 |
| 0,20 | 290 | 0,3 | 50 | 40 | 5,0 | 8,0 |

Tableau No 3

Formule de base: $(Pb_{0,745-y} Ca_{0,255} Cd_y)(Ti_{0,95} Mn_{0,02} Fe_{0,01} Nb_{0,02})O_3$

| y | $\varepsilon_r$ | tg δ (%) | $d_{33} \times 10^{-12}$ C/N | $k_t$ (%) | $k_p$ (%) | $k_t k_p$ |
|---|---|---|---|---|---|---|
| 0,01 | 220 | 0,3 | 71 | 55,0 | 2,0 | 27,5 |
| 0,03 | 190 | 0,6 | 80 | 56,0 | 2,0 | 28,0 |
| 0,04 | 270 | 0,8 | 78 | 55,5 | 1,5 | 32 |
| 0,05 | 290 | 0,8 | 72 | 55,0 | 1,0 | 55 |
| 0,07 | 269 | 0,8 | 73 | 51,5 | 2,0 | 25,8 |

Tableau No 4

| | $\varepsilon_r$ | tg δ (%) | $d_{33} \times 10^{-12}$ C/N | $k_t$ (%) | $k_p$ (%) | $k_t/k_p$ (%) | Q | TC (°C) |
|---|---|---|---|---|---|---|---|---|
| $Pb_{0,76}$ $Ca_{0,24}$ $Ti_{0,95}$ $W_{0,025}$ $O_3$ + 0,5 MnO + 0,5 NiO | 200 | | | 52 | 3 | 17,5 | | |
| $Pb_{0,72}$ $Ca_{0,28}$ $Ti_{0,95}$ $Mn_{0,02}$ $Fe_{0,01}$ $Nb_{0,02}$ $O_3$ | 217 | 0,10 | 75 | 55 | 1 | 55 | 50 | 248 |
| $Pb_{0,695}$ $Ca_{0,255}$ $Cd_{0,05}$ $Ti_{0,95}$ $Mn_{0,02}$ $Fe_{0,01}$ $Nb_{0,02}$ $O_3$ | 230 | 0,8 | 75 | 54 | 1 | 54 | | 226 |
| $Pb_{0,6875}$ $Ca_{0,25}$ $Cd_{0,0625}$ $Ti_{0,95}$ $Mn_{0,02}$ $Fe_{0,01}$ $Nb_{0,02}$ $O_3$ | 240 | 0,80 | 10 | 53 | 1 | 53 | | 261 |
| $Pb_{0,68}$ $Ca_{0,24}$ $Cd_{0,08}$ $Ti_{0,95}$ $Mn_{0,02}$ $Fe_{0,01}$ $Nb_{0,02}$ $O_3$ | 260 | 0,007 | 70 | 53 | 1 | 53 | 40 | 265 |

## Revendications

1. Composé ferroélectrique de structure perovskite du type $A^{2+}$ $B^{4+}$ $O_3$, formé par un titanate de plomb modifié par une substitution isovalente sur le site A comprenant les ions $Pb^{2+}$ et $Ca^{2+}$ et des substitutions hétérovalentes sur le site B, caractérisé en ce qu'il répond à la formule générale suivante :
$(Pb_{1-(x+y)}$ $Ca_x$ $Cd_y)$ $(Ti_{1-(v+w+z)}$ $Mn_v$ $Fe_w$ $X_z)$ $O_3$
avec X = Nb ou Sb et selon laquelle :
$0,22 \leq x \leq 0,30$ ; $0 \leq y \leq 0,18$ ; $0,005 \leq v \leq 0,025$ ;
$0,005 \leq w \leq 0,02$ et $0,01 \leq z \leq 0,035$.

2. Composé ferroélectrique selon la revendication 1, caractérisé en ce que la concentration en ions du site B est de préférence comprise entre les limites suivantes :
$0,01 \leq v \leq 0,02$ ; $0,01 \leq w \leq 0,02$ et $0,015 \leq z \leq 0,025$.

3. Composé ferroélectrique selon la revendication 2, caractérisé en ce que la concentration x en ion $Ca^{2+}$ est de préférence supérieure ou égale à 0,24.

4. Composé ferroélectrique selon l'une des revendications précédentes, caractérisé en ce que la concentration y en ion $Cd^{2+}$ est de préférence comprise entre 0 et 0,14.

5. Composé ferroélectrique selon la revendication 4, caractérisé en ce que les ions $Ca^{2+}$ et $Cd^{2+}$ sont introduits en quantités telles qu'elles satisfont la relation suivante : $0,28 \leq x + y \leq 0,34$.

6. Céramique ferroélectrique obtenue par frittage du composé défini par l'une des revendications précédentes.

## Patentansprüche

1. Ferroelektrische Verbindung mit Perowskitstruktur des Typs $A^{2+}B^{4+}O_3$, gebildet durch ein Bleititanat, das modifiziert ist durch eine gleichwertige Substitution auf der Stelle A, die die Ionen $Pb^{2+}$ und $Ca^{2+}$ umfaßt, und durch anderswertige Substitutionen auf der Stelle B, dadurch gekennzeichnet, daß sie der folgenden allgemeinen Formel entspricht:
$(Pb_{1-(x+y)}$ $Ca_x$ $Cd_y)$ $(Ti_{1-(v+w+z)}$ $Mn_v$ $Fe_w$ $X_z)$ $O_3$
wobei X = Nb oder Sb und
$0,22 \leq x \leq 0,30$; $0 \leq y \leq 0,18$; $0,005 \leq v \leq 0,025$;
$0,005 \leq w \leq 0,02$ und $0,01 \leq z \leq 0,035$.

2. Ferroelektrische Verbindung nach Anspruch 1, dadurch gekennzeichnet, daß die Ionenkonzentration der Stelle B vorzugsweise zwischen den folgenden Grenzen liegt:
$0,01 \leq v \leq 0,02$; $0,01 \leq w \leq 0,02$ und $0,015 \leq z \leq 0,025$.

3. Ferroelektrische Verbindung nach Anspruch 2, dadurch gekennzeichnet, daß die Konzentration x an $Ca^{2+}$-Ionen vorzugsweise größer oder gleich 0,24 ist.

4. Ferroelektrische Verbindung nach einem der vorhergehenden Ansprüche, dadurch gekennzeichnet, daß die Konzentration y an $Cd^{2+}$-Ionen vorzugsweise zwischen 0 und 0,14 liegt.

5. Ferroelektrische Verbindung nach Anspruch 4, dadurch gekennzeichnet, daß die Ionen $Ca^{2+}$ und $Cd^{2+}$ in Mengen eingeführt sind, daß sie der folgenden Beziehung genügen:
$0,28 \leq x+y \leq 0,34$.

6. Ferroelektrische Keramik, erhalten durch Sintern der durch einen der vorhergehenden Ansprüche definierten Verbindung.

## Claims

1. Ferroelectric compound of perovskite structure of the type $A^{2+}B^{4+}O_3$, formed of a lead titanate modified by an isovalent substitution at site A comprising the ions $Pb^{2+}$ and $Ca^{2+}$ and heterovalent substitutions at site B, characterized in that it complies with the following general formula:

$(Pb_{1-(x+y)} Ca_x Cd_y) (Ti_{1-(v+w+z)} Mn_v Fe_w X_z) O_3$

where $X = Nb$ or $Sb$ and according to which:

$0.22 \leq x \leq 0.30; 0 \leq y \leq 0.18; 0.005 \leq v \leq 0.025;$

$0.005 \leq w \leq 0.02$ and $0.01 \leq z \leq 0.035$.

2. Ferroelectric compound according to claim 1, characterized in that the ions concentration of site B preferably lies between the followig limits:

$0.01 \leq v \leq 0.02; 0.01 \leq w \leq 0.02$ and $0.015 \leq z \leq 0.025$.

3. Ferroelectric compound according to claim 2, characterized in that the concentration x in $Ca^{2+}$ ion is preferably greater than or equal to 0.24.

4. Ferroelectric compound according to one of the preceding claims, characterized in that the concentration y in $Cd^{2+}$ ion is preferably from 0 to 0.14.

5. Ferroelectric compound according to claim 4, characterized in that the $Ca^{2+}$ and $Cd^{2+}$ ions are introduced in quantities such that they satisfy the following relationship: $0.28 \leq x + y \leq 0.34$.

6. Ferroelectric ceramic produced by sintering of the compound defined by one of the preceding claims.

Figure 1 – Variation de kp, kt et kt/kp en fonction de x dans les céramiques de composition :

$$Pb_{1-x} \quad Ca_x \quad Ti_{0,95} \quad Mn_{0,02} \quad Fe_{0,01} \quad Nb_{0,02} \quad O_3 -$$

EP 0 229 555 B1

Figure 2 — Variation de kp, kt et kt/kp en fonction de y dans les céramiques de composition :

$Pb_{0,76-y}$ $Ca_{0,24}$ $Cd_y$ $Ti_{0,95}$ $Mn_{0,02}$ $Fe_{0,01}$ $Nb_{0,02}$ $O_3$ —

EP 0 229 555 B1

EP 0 229 555 B1

$k_t/k_p$ | $k_t$ % | | | | | | | | $k_p$ %

$k_t$

$k_t/k_p$

$k_p$

50    53

30    49

10    45

0,02      0,04      0,06      y Cd

Figure 3 - Variation de kp, kt et kt/kp en fonction de y dans les céramiques de composition :

$Pb_{0,735}$    $Ca_{0,255}$    $Cd_y$    $Ti_{0,95}$    $Mn_{0,02}$    $Fe_{0,01}$    $Nb_{0,02}$    $O_3$ -